Europäisches Patentamt

European Patent Office

Office européen des brevets

(11) Publication number: **0 121 069**
**B1**

(12) EUROPEAN PATENT SPECIFICATION

(45) Date of publication of patent specification: **11.01.89**

(51) Int. Cl.⁴: **G 02 B 17/00,** H 01 S 3/00

(21) Application number: **84101727.0**

(22) Date of filing: **20.02.84**

(54) Reflecting system for improving the uniformity of a light beam.

(30) Priority: **31.03.83 US 481011**

(43) Date of publication of application:
**10.10.84 Bulletin 84/41**

(45) Publication of the grant of the patent:
**11.01.89 Bulletin 89/02**

(84) Designated Contracting States:
**DE FR GB**

(56) References cited:
**DE-A-2 916 741**
**US-A-4 192 578**

(73) Proprietor: **International Business Machines Corporation**
**Old Orchard Road**
**Armonk, N.Y. 10504 (US)**

(72) Inventor: **Jain, Kantilal**
**6749 Michele Way**
**San Jose California 95129 (US)**
Inventor: **Latta, Milton Russell**
**7226 Gold Course Lane**
**San Jose California 95139 (US)**

(74) Representative: **Atchley, Martin John Waldegrave**
**IBM United Kingdom Limited Intellectual Property Department Hursley Park**
**Winchester Hampshire SO21 2JN (GB)**

Courier Press, Leamington Spa, England.

## Description

The present invention relates to light beams and more particularly to apparatus for improving the uniformity of the intensity distribution across a light beam.

In many applications in optics a uniform intensity distribution across a light beam is required. The light emitted by most lamp and laser sources does not have a flat intensity profile. As a result, some sort of optical system must be employed to make the intensity of the beam more uniform. One especially important class of light sources is excimer lasers, which have recently been shown to be very attractive for high resolution lithography, an application that typically requires the beam to have a uniform intensity distribution to better than within ±5%. U.S. Patent US—A—3,660,778 to Le Blanc, Sr. discloses a corner reflector laser beam folding device. A laser beam is reflected parallel to the incident beam, increasing the time duration the laser spends in the lasing medium and thereby producing a beam with increased power. IBM Technical Disclosure Bulletin Vol. 24 No. 11A, April 1982, page 5368 discloses a wedge-shaped acrylic light guide used to illuminate a liquid display. The wedge causes multiple internal reflections to concentrate the light on the display surface. Myer in Applied Optics, Vol. 10 No. 9, pages 2179—2182 (1971) describes the use of mirrors forming a cone for replicating images. According to this description a plane parallel mirror tunnel will replicate images in an orthogonal pattern whereas a cone mirror tunnel will replicate images in a virtual spherical pattern. None of the references describes the use of beam folding to increase beam uniformity and to sharpen edge definition.

The object of the present invention is to provide an apparatus for improving the uniformity of the intensity distribution across a light beam.

According to present invention the apparatus for improving the uniformity of the intensity distribution across the width of a light beam is characterized by primary optical means for focusing the beam into a primary focus line extending across the axis of the beam and a primary plane reflecting surface located so as to reflect the beam in the region of the primary focus line, the primary plane reflecting surface being located so that the primary focus line extends parallel to and adjacent to a front edge of the primary plane reflecting surface, and the primary plane reflecting surface being parallel to or slightly inclined at a first angle to the axis of the beam.

According to a preferred embodiment of the invention the apparatus of the above type is characterised by an additional primary plane reflecting surface located so as to reflect the beam in the region of the primary focus line, the additional primary plane reflecting surface being located so that the primary focus line extends parallel to and adjacent to a front edge of the additional primary plane reflecting surface, and the additional primary plane reflecting surface being inclined at a second angle to the axis of the beam.

The action of reflecting the light beam at each primary plane reflecting surface folds the beam onto itself and improves the uniformity of the intensity distribution across the beam.

In order that the invention may be more readily understood reference will now be made to the Figures of the accompanying drawings, in which:

Figures 1A—1E illustrate the profile of a light beam and a method of improving the uniformity of the intensity across the beam which can be implemented by using apparatus in accordance with the present invention,

Figures 2A, 2B and 2C are schematic views of three embodiments of apparatus in accordance with the invention having one, two and three mirrors respectively,

Figure 3 illustrates an alternative embodiment of the invention,

Figure 4 is a schematic view of a further embodiment of the invention, and

Figures 5A and 5B illustrate the input and output intensity distributions of a light beam used with the apparatus illustrated in Figure 6.

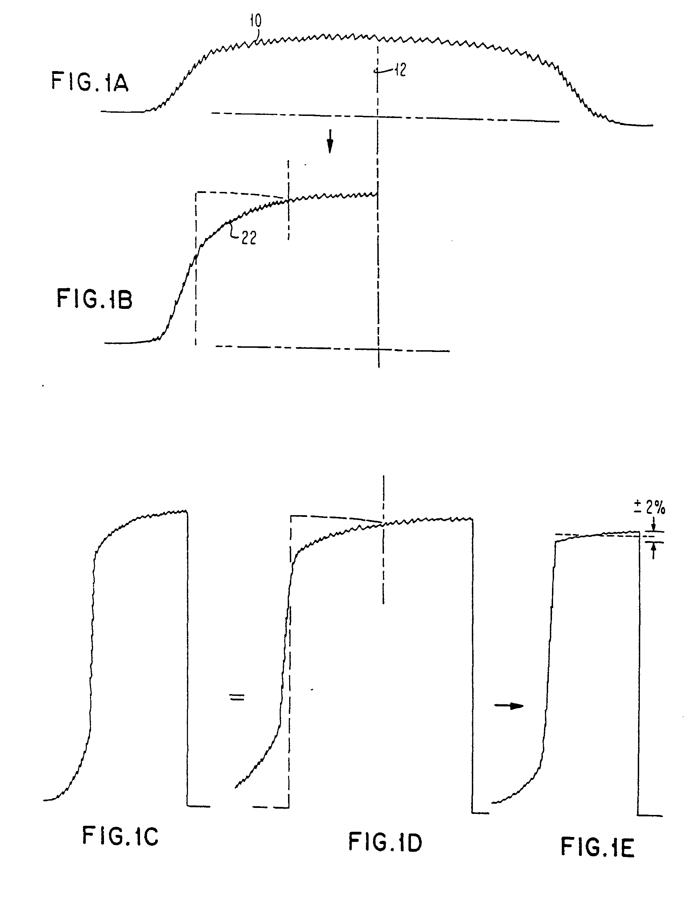

As shown in Figure 1A, the intensity across a beam from a laser source that is to be made more uniform has a profile 10. The profile 10 of the intensity is substantially the same on either side of the axis 12. By utilising apparatus in accordance with the present invention, the beam is made uniform by folding it onto itself one or more times about an axis such as the axis 12. The folding process averages out the short-range noise-like fluctuations as well as the systematic long-range variations in the original profile of the intensity.

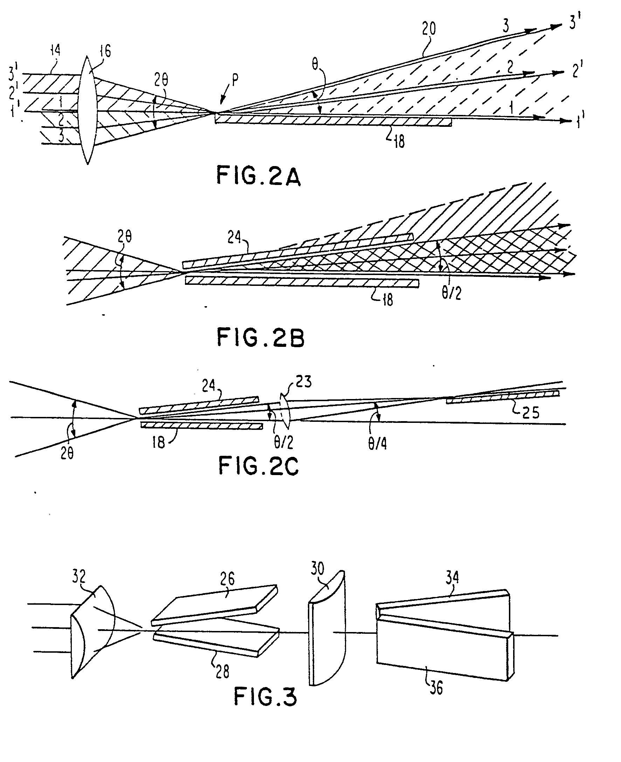

As shown in Figure 2A, the beam 14 to be made more uniform is converted, using a primary optical system consisting of a cylindrical lens 16, into a wedged shaped beam which is focussed into a primary focus line at P. The line P is located near the end of a primary plane reflecting surface consisting of a plane mirror 18 placed near the axis of the beam and with its reflecting surface extending parallel to the axis of the beam. The line P extends out of the plane of the paper parallel to the reflecting surface of the mirror 18. The wedge angle of the light beam incident at P is 2θ in the plane of the paper. From the position of the mirror it can be seen that the lower half of the incident wedged shaped beam, as denoted by rays 1, 2 and 3, leaves the mirror without reflection. On the other hand, the upper half of the incident wedged shaped beam, as denoted by rays 1′, 2′ and 3′ undergoes one reflection at the mirror surface and folds over to overlap with the unreflected half of the beam to form a beam 20. The profile 22 of the intensity across the beam 20 after reflection by the mirror 18 is shown in Figure 1B. The divergence of the beam 20 in the plane of the paper is θ, that is one-half of the incident wedge angle. While this folding operation reduces the fluctuation noise, it does not flatten the profile.

When an additional primary reflecting surface consisting of a second mirror 24 is placed with one end adjacent to the line P and with its reflecting surface extending at angle θ/2 to the reflecting surface of the first mirror 18 to form a mirror wedge tunnel, as shown in Figure 2B, the beam undergoes a further reflection at the surface of mirror 24 and is thereby folded over once more and the profile of its intensity across its width has a shape of the type shown in Figure 1C or in an expanded form as shown in Figure 1D.

A third reflection will provide the beam with a profile as shown in Figure 1E which has a high degree of uniformity. This third reflection can be obtained in several ways. One way is to refocus by means of a cylindrical lens 23 the light beam emerging from mirrors 18 and 24 into a line near the end of a further plane mirror 25 the reflecting surface of which lies parallel to the axis of the beam on emergence from the lens 23. The third reflection may alternatively be obtained more simply by making the angle between the first two mirrors 18 and 24 θ/4, instead of θ/2 as shown in Figure 2B.

In general, if n reflections are wanted, the angle between the mirrors 18, 24 must be $\theta/2^n$, where θ is the incident wedge angle. When the combination of the two mirrors 18, 24 as shown in Figure 2C is used it is not necessary for either of the reflecting surfaces of the mirrors to extend accurately parallel to the axis of the incident wedge shaped beam. This allows the possibility of folding the beam about some line other than the axis of the beam which defines the centre of the input intensity distribution. In addition, since a finite entrance gap is required between the mirrors, the overlap will be slightly less than 100%. As a result, a little cropping will be required to pick out the most uniform portion of the beam thereby making the throughput slightly less than 100%.

As shown in Figure 3, an improvement of the uniformity in two orthogonal directions can be achieved by the use of two mirror wedge tunnels. The first wedge tunnel consists of mirrors 26 and 28 which fold a beam emerging from a cylindrical lens 32 as described with reference to mirrors 18, 24 in Figure 2C and then direct the beam to a cylindrical lens 30 that has its axis at 90° to the axis of the first lens 32. The second wedge tunnel consists of mirrors 34 and 36 which are oriented at 90° to mirrors 26 and 28 and fold the beam in directions orthogonal to the directions of folding performed by mirrors 26, 28.

In any of the configurations described above, the output light beam will be diverging after the final reflection. It is desirable to use an additional lens, focused on the primary focus line P, in order to render the output light beam collimated and, thus, more generally useful.

Example

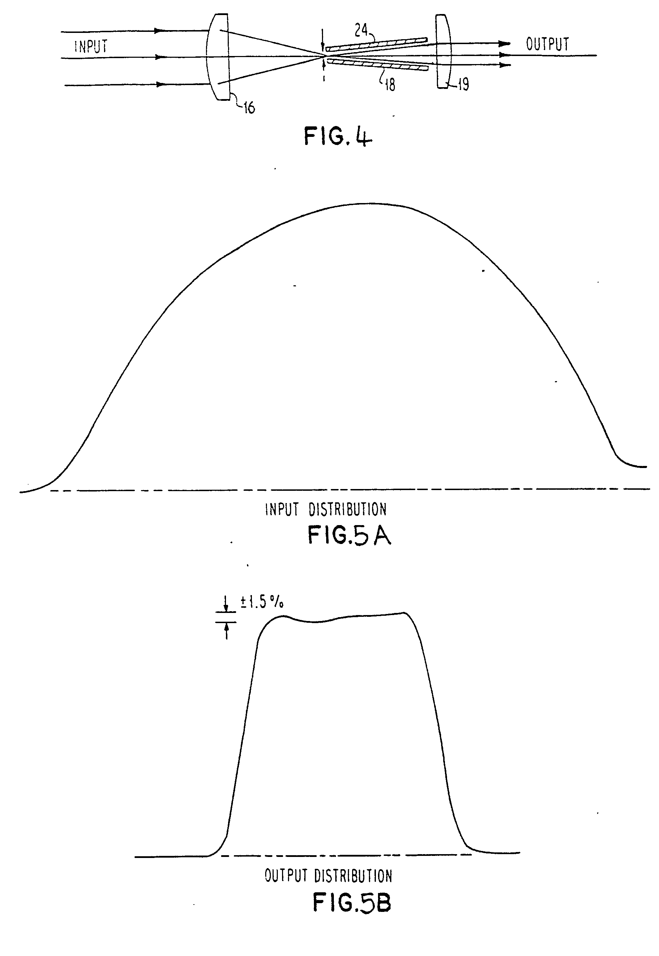

An experimental device was made as in Figure 4. Input 16 and output 19 cylindrical lenses of 100 mm and 80 mm focal length respectively were used to focus the incident light beam and subsequently to collimate it. Two plane mirrors 18 and 24 with their reflecting surfaces lying in planes inclined at an angle of 8° and separated at one end by a gap of $5.08 \times 10^{-4}$ m (0.020 inch) were positioned about the focal line of lens 16. In this case, two reflections were produced and the beam folding occurred at two mid-points of the intensity distribution. The input and output intensity distributions of the beam when used with the device in Figure 6 are shown in Figures 5A and 5B respectively.

**Claims**

1. Apparatus for improving the uniformity of the intensity distribution across the width of a light beam characterised by
   primary optical means (16) for focusing said beam into a primary focus line (P) extending across the axis of said beam, and
   a primary plane reflecting surface (18) located so as to reflect said beam in the region of said primary focus line,
   said primary plane reflecting surface being located so that said primary focus line extends parallel to and adjacent to a front edge of said primary plane reflecting surface, and said primary plane reflecting surface being parallel to or slightly inclined at a first angle to said axis of said beam.

2. Apparatus as claimed in claim 1 characterised in that said primary focus line extends perpendicular to the axis of said beam.

3. Apparatus as claimed in either of the preceding claims characterised by an additional primary plane reflecting surface (24) located so as to reflect said beam in the region of said primary focus line,
   said additional primary plane reflecting surface being located so that said primary focus line extends parallel to and adjacent to a front edge of said additional primary plane reflecting surface, and said additional primary plane reflecting surface being inclined at a second angle to said axis of said beam.

4. Apparatus as claimed in claim 3 characterised by further optical means (23) located so as to receive said beam on emergence from said primary plane reflecting surfaces and operable to focus said emergent beam into a further focus line extending across the axis of said emergent beam and substantially parallel to said primary focus line, and a further plane reflecting surface (25) located so as to reflect said emergent beam in the region of said further focus line,
   said further plane reflecting surface being located so that said further focus line extends parallel to and adjacent to a front edge of said further plane reflecting surface, and said further plane reflecting surface extending parallel to the axis of said emergent beam.

5. Apparatus as claimed in claim 3 characterised by a secondary optical means (30) located so as to receive said beam on emergence from said primary plane reflecting surfaces and operable to focus said emergent beam into a secondary focus line extending across the axis of said emergent beam and substantially at right angles to said primary focus line and a secondary plane reflecting surface (34) located so as to reflect said emergent beam in the region of said secondary focus line,

said secondary plane reflecting surface being located so that said secondary focus line extends parallel to and adjacent to a front edge of said secondary plane reflecting surface, and said secondary plane reflecting surface being parallel to or slightly inclined at a third angle to said axis of said emergent beam.

6. Apparatus as claimed in claim 5 characterised in that said secondary focus line extends perpendicular to the axis of said emergent beam.

7. Apparatus as claimed in either claim 5 or claim 6 characterised by an additional secondary plane reflecting surface (36) located so as to reflect said emergent beam in the region of said secondary focus line,

said additional secondary plane reflecting surface being located so that said secondary focus line extends parallel to and adjacent to a front edge of said additional secondary plane reflecting surface, and said additional secondary plane reflecting surface being inclined at a fourth angle to said axis of said emergent beam.

**Patentansprüche**

1. Vorrichtung zur Verbesserung der Gleichförmigkeit der Intensitätsverteilung über die Breite eines Lichtbündels, gekennzeichnet durch

primäre optische Mittel (16) zur Fokussierung des Bündels in eine primäre Brennlinie (P), die sich quer zur Achse des Bündels erstreckt, und

eine primäre plane reflektierende Fläche (18), die so angeordnet ist, daß sie das Bündel im Bereich der primären Brennlinie reflektiert,

wobei die primäre plane reflektierende Fläche so angeordnet ist, daß sich die primäre Brennlinie parallel und benachbart zu einem vorderen Rand der primären planen reflektierenden Fläche erstreckt, und die primäre plane reflektierende Fläche parallel oder unter einem ersten Winkel leicht geneigt zur Achse des Bündels ist.

2. Vorrichtung nach Anspruch 1, dadurch gekennzeichnet, daß sich die primäre Brennlinie senkrecht zur Achse des Bündels erstreckt.

3. Vorrichtung nach irgendeinem der vorstehenden Ansprüche, gekennzeichnet durch eine zusätzliche primäre plane reflektierende Fläche (24), welche so angeordnet ist, daß das Bündel im Bereich der primären Brennlinie reflektiert wird,

wobei die zusätzliche primäre plane reflektierende Fläche so angeordnet ist, daß die primäre Brennlinie sich parallel und benachbart zu einem vorderen Rand der zusätzlichen primären planen reflektierenden Fläche erstreckt, und die zusätzliche primäre plane reflektierende Fläche unter einem zweiten Winkel zur Achse des Bündels geneigt ist.

4. Vorrichtung nach Anspruch 3, gekennzeichnet durch weitere optische Mittel (23), die so angeordnet sind, daß sie das Bündel beim Abgehen von den primären planen reflektierenden Flächen erhalten und dahingehend wirksam sind, daß sie das abgehende Bündel in eine weitere Brennlinie fokussieren, die sich quer Achse des abgehenden Bündels und im wesentlichen parallel zu der primären Brennlinie erstreckt, und eine weitere plane reflektierende Fläche (25), welche so angeordnet ist, daß das abgehenden Bündel im Bereich der weiteren Brennlinie reflektiert wird,

wobei die weitere plane reflektierende Fläche so angeordnet ist, daß sich die weitere Brennlinie parallel und benachbart zu einem vorderen Rand der weiteren planen reflektierenden Fläche erstreckt, und die weitere plane reflektierende Fläche sich parallel zur Achse des abgehenden Bündels erstreckt.

5. Vorrichtung nach Anspruch 3, gekennzeichnet durch sekundäre optische Mittel (30), welche so angeordnet sind, daß sie das Bündel beim Abgehen von den primären planen reflektierenden Flächen erhalten und dahingehend wirksam sind, daß sie das abgehende Bündel in eine sekundäre Brennlinie fokussieren, die sich quer zur Achse des abgehenden Bündels und im wesentlichen in rechtem Winkel zur primären Brennlinie erstreckt, und eine sekundäre plane reflektierende Fläche (34), welche so angeordnet ist, daß das abgehende Bündel im Bereich der sekundären Brennlinie reflektiert wird,

wobei die sekundäre plane reflektierende Fläche so angeordnet ist, daß sich die sekundäre Brennlinie parallel und benachbart zu einem vorderen Rand der sekundären planen reflektierenden Fläche erstreckt, und die sekundäre plane reflektierende Fläche parallel oder unter einem dritten Winkel leicht geneigt zur Achse des abgehenden Bündels ist.

6. Vorrichtung nach Anspruch 5, dadurch gekennzeichnet, daß sich die sekundäre Brennlinie senkrecht zur Achse des abgehenden Bündels erstreckt.

7. Vorrichtung nach Anspruch 5 oder 6, gekennzeichnet durch eine zusätzliche sekundäre plane reflektierende Fläche (36), welche so angeordnet ist, daß das abgehende Bündel im Bereich der sekundären Brennlinie reflektiert wird,

wobei die zusätzliche sekundäre plane reflektierende Fläche so angeordnet ist, daß die sekundäre Brennlinie sich parallel und benachbart zu einem vorderen Rand der zusätzlichen sekundären planen reflektierenden Fläche erstreckt, und die zusätzliche sekundäre plane reflektierende Fläche unter einem vierten Winkel zur Achse des abgehenden Bündels geneigt ist.

**Revendications**

1. Dispositif pour améliorer l'uniformité de la distribution d'intensité sur l'étendue en largeur d'un faisceau de lumière, caractérisé par

des moyens optiques primaires (16) servant à focaliser ledit faisceau sur une ligne focale primaire (P) s'étendant transversalement par rapport à l'axe dudit faisceau, et

une surface plane primaire réfléchissante (18) disposée de manière à réfléchir ledit faisceau dans la région de ladite ligne focale primaire,

ladite surface plane primaire réfléchissante étant située de sorte que ladite ligne focale primaire s'étend parallèlement à et au voisinage d'un bord avant de ladite surface plane primaire réfléchissante, et ladite surface plane primaire réfléchissante étant parallèle audit axe dudit faisceau ou légèrement inclinée selon un premier angle par rapport à cet axe.

2. Dispositif selon la revendication 1, caractérisé en ce que ladite ligne focale primaire est perpendiculaire à l'axe dudit faisceau.

3. Dispositif selon l'une des revendications précédentes, caractérisé par une surface plane primaire réfléchissant additionnelle (24) située de manière à réfléchir ledit faisceau dans la région de ladite ligne focale primaire,

ladite surface plane primaire réfléchissante additionnelle étant située de telle sorte que ladite ligne focale primaire s'étend parallèlement à et au voisinage d'un bord avant de ladite surface plane primaire réfléchissante additionnelle, et ladite surface plane primaire réfléchissante additionnelle étant inclinée selon un second angle par rapport audit axe dudit faisceau.

4. Dispositif selon la revendication 3, caractérisé par des moyens optiques supplémentaires (23) situés de manière à recevoir ledit faisceau lors de son émergence à partir desdites surfaces planes primaires réfléchissantes et pouvant agir de manière à focaliser ledit faisceau émergent le long d'une autre ligne focale s'étendant transversalement par rapport à l'axe dudit faisceau émergent et sensiblement parallèle à ladite ligne focale primaire, et une autre surface plane réfléchissante (25) située de manière à réfléchir ledit faisceau émergent dans la région de ladite autre ligne focale,

ladite autre surface plane réfléchissante étant située de manière que ladite autre ligne focale s'étend parallèlement à et au voisinage d'un bord avant de ladite autre surface plane réfléchissante, et ladite autre surface plane réfléchissante s'étendant parallèlement à l'axe dudit faisceau émergent.

5. Dispositif selon la revendication 3, caractérisé par des moyens optiques secondaires (30) situés de manière à recevoir ledit faisceau lors de son émergence à partir desdites surfaces planes primaires réfléchissantes et pouvant agir de manière à focaliser ledit faisceau émergent suivant une ligne focale secondaire s'étendant transversalement par rapport à l'axe dudit faisceau émergent et sensiblement perpendiculairement à ladite ligne focale primaire, et une surface plane réfléchissante secondaire (34) située la manière à réfléchir ledit faisceau émergent dans la région de ladite ligne focale secondaire,

ladite surface plane réfléchissante secondaire étant située de telle sorte que ladite ligne focale secondaire s'étend parallèlement à et au voisinage d'un bord avant de ladite surface réfléchissante plane secondaire, et ladite surface réfléchissante plane secondaire étant parallèle audit axe dudit faisceau émergent ou légèrement inclinée selon un troisième angle par rapport à cet axe.

6. Dispositif selon la revendication 5, caractérisé en ce que ladite ligne focale secondaire s'étend perpendiculairement à l'axe dudit faisceau émergent.

7. Dispositif selon la revendication 5 ou 6, caractérisé par une surface plane réfléchissante secondaire additionnelle (36) située de manière à réfléchir ledit faisceau émergent dans la région de ladite ligne focale secondaire,

ladite surface plane réfléchissante secondaire additionnelle étant située de telle sorte que ladite ligne focale secondaire est parallèle à et voisine d'un bord avant de ladite surface plane réfléchissante secondaire additionnelle, et ladite surface plane réfléchissante secondaire additionnelle étant inclinée selon un quatrième angle par rapport audit axe dudit faisceau émergent.

FIG.1A

FIG.1B

FIG.1C    FIG.1D    FIG.1E

FIG.2A

FIG.2B

FIG.2C

FIG.3

FIG.4

INPUT DISTRIBUTION

FIG.5A

±1.5 %

OUTPUT DISTRIBUTION

FIG.5B